**Europäisches Patentamt**

**European Patent Office**

**Office européen des brevets**

(19)

(11) Publication number : **0 491 539 A1**

## (12) EUROPEAN PATENT APPLICATION

(21) Application number : **91311665.3**

(22) Date of filing : **16.12.91**

(51) Int. Cl.⁵ : **H05K 13/00**

(30) Priority : **19.12.90 US 629991**

(43) Date of publication of application :
**24.06.92 Bulletin 92/26**

(84) Designated Contracting States :
**DE FR GB IT**

(71) Applicant : **EMHART INC.**
**Drummond Plaza Office Park, 1423, Kirkwood Highway**
**Newark, Delaware 19711 (US)**

(72) Inventor : **Bandura, Vitaly**
**18 College Pond Drive**
**Danvers, Massachusetts 01923 (US)**

(74) Representative : **Stagg, Diana Christine et al**
**Emhart Patents Department Lyn House 39 The Parade**
**Oadby Leicester LE2 5BB (GB)**

(54) **Machine for mounting electronic components.**

(57)   A printed circuit board 10 is clamped to the rail of an X-Y table 17 by a pair of clamping assemblies 22 which each have a support rail 16 carrying a number of pivotally displaceable clamping elements 26. These clamping elements 26 are spring biassed to the clamping position and will be simultaneously released by displacement of a control bar 32 carrying pins 34 which will engage the clamping elements 26 to displace them to a release position.

FIG. I

EP 0 491 539 A1

Electronic components are mounted on printed circuit boards in machines which are referred to as surface mount assembly machines where the components are surface mounted and through hole assembly machines where the components have leads which are inserted into holes in the printed circuit board. The circuit boards are clamped on a movable table so that they can be X-Y displaced to position the board correctly relative to the component to be mounted.

Conventional clamping techniques use pins which are positively displaced from a retracted position to an advanced clamping position. These structures require adjustment during set up to define properly the displacement stroke.

It is an object of the present invention to provide a clamping assembly for clamping a printed circuit board on the movable table of an electronic component placement machine which requires no adjustments during use.

The present invention provides a machine for mounting electronic components on a printed circuit board comprising an X-Y table including opposing side rails, the side rails each including, means for supporting and conveying a printed circuit board, characterised in that the machine further comprises flange means projecting over the edge of the circuit board, a plurality of clamp means, spring means for urging the plurality of clamp means towards a clamping location where the edge of the circuit board will be clamped against the flange means, and selectively operable means for conjointly retracting the clamp means against the urging of the spring means from the clamping position to a release position where the conveyor can again convey the supported printed circuit board.

A machine for mounting electronic components on a printed circuit board will now be further described with reference to the accompanying drawings in which:

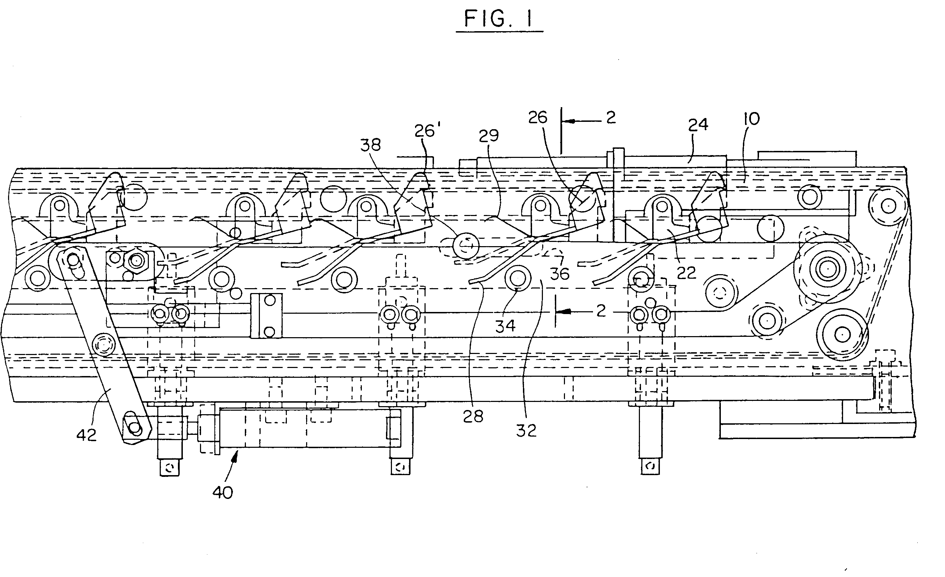

Figure 1 is an elevational side view of one side of the X-Y table of an assembly machine; and

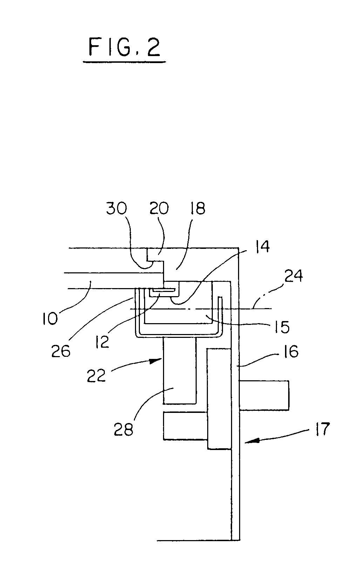

Figure 2 is a view taken at 2-2 of Figure 1 with the clamps in the release position.

Each side edge of a printed circuit board 10 is supported by a conveyor belt 12 which runs within a suitable groove 14 defined in an elongated left guide 15 which is secured to the frame 16 of an X-Y table 17. The conveyor belt is partially captured by an inwardly projecting lower flange 18 of the frame and the edge of the board is captured by an inwardly projecting upper frame flange 20.

A number of spring clamps 22 are pivotally secured at one side of the rail to support pins 24 carried by the rail 16. Each spring clamp 22 has a clamping element 26 and a tab 28 that extends downmwardly at an angle to the rail. A spring 29 is secured to the spring clamp and forcefully engages the lower surface of the left guide to rotate the clamp counterclockwise to its uppermost position 26' where further movement is blocked by the left guide. As a result the clamp will forcefully engage the lower surface of the printed circuit board clamping the beard against the lower surface 30 of the upper flange 20.

An elongated control bar 32 has a corresponding number of actuator pins 34 and the control bar has a plurality of horizontally extending slots 36 which receive support pins 38 secured to the frame 16 so that the control bar can be displaced from a release position where the actuator pins have engaged the clamp tabs 28 and rotated the cramping element 26 clockwise to the retracted position to a clamping position where the actuator pins are remote from the clamp tabs 28 and the clamping element allowing the spring 29 to force the board against the flange 30 to clamp it in position. A double acting arm cylinder acting through a pivoting linkage 42 controls the displacement of the control bar.

## Claims

1. A machine for mounting electronic components on a printed circuit board 10 comprising
   an X-Y table 17 including opposing side rails 16, the side rails 16 each including
   means 12 for supporting and conveying a printed circuit board 10, characterised in that the machine further comprises flange means 20 projecting over the edge of the circuit board 10,
   a plurality of clamp means 22,
   spring means 29 for urging the plurality of clamp means 22 towards a clamping location where the edge of the circuit board 10 will be clamped against the flange means 20, and
   selectively operable means 32 for conjointly retracting the clamp means 22 against the urging of the spring means 29 from the clamping position to a release position where the conveyor 12 can again convey the supported printed circuit board 10.

2. A machine for mounting electronic components on a printed circuit board 10 according to claim 1, characterised in that the conjointly retracting means 32 comprises a single double acting cylinder.

FIG. 1

## FIG. 2

**European Patent Office**

## EUROPEAN SEARCH REPORT

Application Number

EP 91 31 1665

### DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| A | IBM TECHNICAL DISCLOSURE BULLETIN. vol. 31, no. 9, February 1989, NEW YORK US pages 103 - 105; 'Printed circuit board back-up mechanism' * the whole document * | 1,2 | H05K13/00 |
| | ----- | | |
| | | | **TECHNICAL FIELDS SEARCHED (Int. Cl.5)** |
| | | | H05K B65G |

The present search report has been drawn up for all claims

| Place of search | Date of completion of the search | Examiner |
|---|---|---|
| THE HAGUE | 04 FEBRUARY 1992 | RIEUTORT A.S. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P0401)